# EUROPÄISCHE PATENTSCHRIFT

(11) **EP 1 044 589 B1**
(45) Veröffentlichungstag und Bekanntmachung des Hinweises auf die Patenterteilung: **27.02.2002**
(21) Anmeldenummer: 98965068.4
(22) Anmeldetag: 12.11.1998
(51) Int. Cl.: H05K 7/14

(54) **VORRICHTUNG ZUM HALTEN VON PROZESSORMODULEN**
DEVICE FOR HOLDING PROCESSOR MODULES
DISPOSITIF DE MAINTIEN POUR MODULES PROCESSEURS

(30) Priorität: 13.11.1997 DE 19750341
(43) Veröffentlichungstag der Anmeldung: 18.10.2000
(73) Patentinhaber: Fujitsu Siemens Computers GmbH, 81739 München (DE)
(72) Erfinder: PETRY, Florian, D-86179 Augsburg (DE); AUNER, Peter, D-81825 München (DE); MATSUDA, Eiji, Chiba-ken 285 (JP)
(74) Vertreter: Hermann, Uwe, Dipl.-Ing.
(86) Internationale Anmeldenummer: DE9803330
(87) Internationale Veröffentlichungsnummer: WO9926459

(56) Entgegenhaltungen:
- GB-A- 1 585 264
- US-A- 4 068 290

## Beschreibung

Die Erfindung betrifft eine Vorrichtung zum Halten von Prozessormodulen gemäß dem Oberbegriff des Anspruchs 1.

Für neuartige Prozessortypen, beispielsweise solchen, die unter dem Namen Pentium 2 bekannt sind, wird, im Gegensatz zu bisherigen Montagemethoden, ein massiges und damit schweres Prozessormodul verwendet, das auf einer als Trägerplatte dienenden Leiterplatte senkrecht in einen Direktstecker gesteckt wird. Damit entfallen die bisher für Prozessoren verwendeten, parallel zur Leiterplatte angeordneten und somit einen großen Flächenbedarf auf der Leiterplatte benötigenden Adaptersokkel. Das Prozessormodul ist deshalb so massig und schwer, weil es unter anderem gleich mit einer Kühleinrichtung versehen ist.

Zur mechanischen Befestigung des Prozessormoduls in dem Direktstecker wird ein sogenanntes "retention modul" verwendet. Das "retention modul" verhindert ein Herausfallen des Prozessormoduls bei Vibrations-, Schock- oder sonstigen mechanischen Belastungen. Das "retention modul" ist daher entsprechend stabil gebaut.

Das "retention modul" umfasst ein Rahmenteil, das auf der Leiterplatte den Direktstecker umrahmt. Zur Befestigung des Rahmenteils auf der Leiterplatte weist das Rahmenteil an äußeren Rändern Befestigungspunkte mit Anlageschultern für entsprechende Befestigungselemente auf. Am Rahmenteil sind an zwei gegenüberliegenden Seiten zum Führen und Halten des senkrecht in den Direktstecker einzusteckenden bzw. eingesteckten Prozessormoduls senkrecht von der Leiterplatte abstehende Führungsschienenstutzen angeordnet. Die Führungsschienenstutzen sind dabei steif mit dem Rahmenteil verbunden.

Zum "retention modul" gehören weiter auf der dem Rahmenteil gegenüberliegenden Seite der Leiterplatte sogenannte Brücken, die aus einem stabilen Material bestehen. Die Brücken weisen an ihren jeweiligen Enden Befestigungspunkte auf, die jeweils Befestigungspunkten des Rahmenteils auf der anderen Seite der Leiterplatte zugeordnet sind. Die Brücken sind an zwei weitest auseinander liegenden Positionen des "retention moduls" platziert, so dass dazwischen das Prozessormodul eingesetzt werden kann.

Die als Trägerplatte dienende Leiterplatte weist an den Stellen, an denen Befestigungspunkte des Rahmenteils und Befestigungspunkte der Brücken zusammenfallen, fluchtende Öffnungen für einen Durchgriff von Befestigungselementen auf.

Werden als Befestigungselemente Schrauben verwendet, die durch die Befestigungspunkte des Rahmenteils und die fluchtenden Öffnungen der Leiterplatte greifen, sind im Gegensatz dazu die Befestigungspunkte an den Brücken mit Schraubenmuttern versehen, in denen die Schrauben gegengehalten werden. Die von Seiten des Rahmenteils herangeführten Schrauben stützen sich an den Anlageschultern der Befestigungspunkte des Rahmenteils ab. Werden die Schrauben festgezogen, klemmen die stabilen Brücken und das Rahmenteil die Leiterplatte zwischen sich ein. Das "retention modul" wird dadurch auf der Leiterplatte fixiert.

Die Befestigungspunkte an den Brücken können auch in der Weise ausgebildet sein, dass sie anstelle von Muttern mit Schraubenbolzen versehen sind. Die vom Rahmenteil herangeführten Befestigungselemente sind dann als Muttern ausgebildet, beispielsweise in Form von schraubbaren Mutternhülsen. Die Mutternhülsen stützen sich an den Anlageschultern der Befestigungspunkte des Rahmenteils ab. Insgesamt bleibt das Befestigungsprinzip des "retention moduls" auf der Leiterplatte gleich, das heißt, das Rahmenteil und die Brücken klemmen die Leiterplatte zwischen sich ein.

Unabhängig von der Zuordnung von Muttern und Schraubenbolzen zu den Befestigungspunkten des Rahmenteils bzw. der Brücken werden die Brücken in eigenständigen Montageschritten auf der Unterseite der Leiterplatte montiert. Sie werden insbesondere in entsprechende Ausnehmungen an der Leiterplatte aufwendig eingepresst. Die Brücken werden auf diese Weise zu einem festen Bestandteil der Leiterplatte. In einem unabhängigen weiteren Montageschritt wird das Rahmenteil mit den steif abstehenden Führungsschienenstutzen montiert. Dieser Montageschritt wird häufig bis zu einem letzten möglichen Zeitpunkt vor der Verwendung der Leiterplatte mit dem Prozessormodul zurückgestellt, weil die sperrigen Führungsschienenstutzen sonst in der Zwischenzeit Probleme bereiten. Wegen der senkrecht abstehenden Führungsschienenstutzen liegt bei den Leiterplatten eine große Bauhöhe vor, die beispielsweise das Stapeln, das Transportieren und das Verpacken wesentlich erschweren. Auch das Verarbeiten wird erschwert. Beispielsweise können mit einem "retention modul" bestückte Leiterplatten nicht mehr schwallgelötet werden, weil die Maschinen nicht für Baugruppen mit einer solchen Bauhöhe ausgelegt sind. Insgesamt ist die Montage eines "retention moduls" aufgrund der Verwendung von Brücken und Schraubenverbindungen sehr aufwendig und unpraktisch.

Die oben beschriebene Montageart oben angesprochener Prozessormodule mit zugehöriger Halterung ist aus "Mechanical Assembly and Customer Manufacturing Technology for S.E.C. Cartridge Processors", Application Note AP-588, Intel Corporation, Juli 1997, Seiten 20-27 und 50 bekannt.

Aufgabe der vorliegenden Erfindung ist es, eine Vorrichtung zum Halten von massigen und damit schweren Prozessormodulen für neuartige Prozessortypen auf Trägerplatten anzugeben, die fest genug gebaut und stabil genug gehalten ist, um ein solch schweres Prozessormodul zu halten beziehungsweise zu befestigen, die aber trotzdem rasch montiert und demontiert werden kann. Außerdem soll sie platzsparend sein, so dass die einzelnen Montagelinien bei der Bestückung von Trägerplatten ohne große Probleme mitsamt der Halterung durchlaufen werden können.

Diese Aufgabe wird durch die Merkmale des Anspruchs 1 gelöst.

Mit der erfindungsgemäßen Haltevorrichtung wird bei Leiterplatten trotz der Bestückung mit einem "retention modul" eine geringe Bauhöhe erzielt, so dass mit einem "retention modul" bestückte Leiterplatten wie bisher mit den vorhandenen Mitteln und Möglichkeiten behandelt werden können. Das trifft nicht nur auf Transport und Verpackung sondern auch auf die Verarbeitung in einer Schwalllötanlage zu. Mit der erfindungsgemäßen Haltevorrichtung wird auch der Montagevorgang vereinfacht. Insbesondere die nach dem Einschnappprinzip arbeitenden Befestigungselemente ermöglichen eine sehr schnelle und einfache Montage. Brücken, die vorab zu montieren sind, sind nicht mehr nötig. Andererseits besteht aber immer noch die Möglichkeit, die erfindungsgemäße Haltevorrichtung mit den bekannten Brücken und den herkömmlichen Befestigungselementen zu verwenden. Es ist somit vielseitig verwendbar.

Vorteilhafte Ausgestaltungen der Erfindung sind Gegenstand von Unteransprüchen.

Die Montage mit Einschnappbefestigungselementen kann entweder mit unmittelbar an der Haltevorrichtung angeformte Spreizkrallen erfolgen, oder mit entsprechenden Spreizkrallen, die Teil von sogenannten Einschnappbolzen sind. Die zuletzt genannten Befestigungselemente haben den zusätzlichen Vorteil, dass an Stelle der Befestigung mit Einschnappbolzen auch noch die Befestigung mit Schrauben und Brücken gewählt werden kann.

Weisen die Einschnappbefestigungselemente an ihren Längsachsen Durchgangsbohrungen auf, in die Klemm- bzw. Einschnappstifte platzierbar sind, kann dadurch ein Zurückfedern der Spreizkrallen und damit zusammenhängend ein Herausgleiten der Spreizkrallen aus den Durchgangsöffnungen der Leiterplatte verhindert werden. Insgesamt wird dadurch eine sehr hohe Befestigungskraft für die Haltevorrichtung erzielt. Eine sehr hohe Haltekraft wird auch erzielt, wenn die Spreizkrallen lötbar ausgeführt sind und bei der Montage gelötet werden. Das Löten kann mit dem Schwalllöten der Leiterplatte erfolgen, da die Leiterplatte mit der erfindungsgemäßen Haltevorrichtung in Schwalllötanlagen ohne Probleme passt. Eine weitere Erhöhung der Haltekraft ist dadurch zu erzielen, dass der Kantenverlauf der Spreizkrallen derart gewählt ist, dass das Lot in den Durchgangsöffnungen der Leiterplatte beim Löten eine Kapillarwirkung erfährt. Durch die Kapillarwirkung sammelt sich an den Lötstellen mehr Lot an, so dass die Lötstelle verstärkt wird. Besonders vorteilhaft ist, wenn die in die Durchgangsbohrungen der Einschnappbolzen bzw. der einstückig angeformten Spreizkrallen einzubringenden Stifte schnappbar sind, weil dann auch eine Sicherung gegen ungewolltes Herausfallen der Stifte gegeben ist.

Nachfolgend wird die Erfindung anhand einer Zeichnung näher erläutert. Darin zeigen:
- Figuren 1 bis 3: eine bekannte Haltevorrichtung nach dem Stand der Technik in einer Drauf-, Vorder- und Seitenansicht,
- Figuren 4 und 5: eine erfindungsgemäße Haltevorrichtung in einer Seiten- und Draufsicht, und
- Figuren 6 und 7: einen Einschnappbolzen gemäß der Erfindung in zwei Bewegungszuständen an einer teilweise in Schnittdarstellung gezeigten Befestigungsstelle des Rahmenteils.

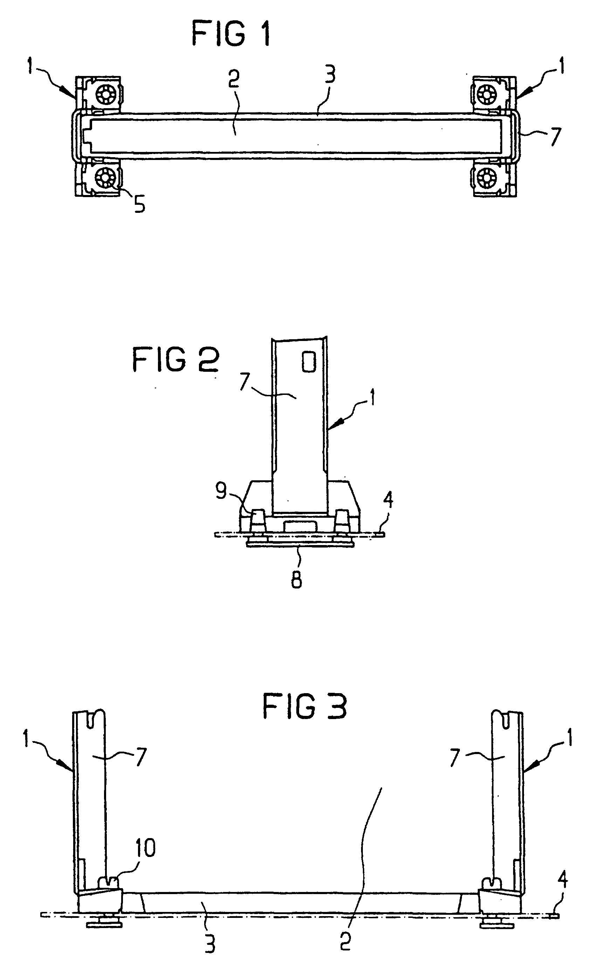

Von den Figuren 1 bis 3 zeigt Figur 1 eine bekannte Haltevorrichtung 1 für an der Position 2 vorzusehende, rechteckförmige Prozessormodule in Draufsicht. In der Figur 2 ist diese Haltevorrichtung in der Vorderansicht und in der Figur 3 in Seitenansicht zu sehen. Ein Prozessormodul ist eine mit einem Prozessorbaustein auf einer Leiterplatte aufgebaute Schaltungseinheit, die in der Regel von einem Gehäuseteil geschützt ist.

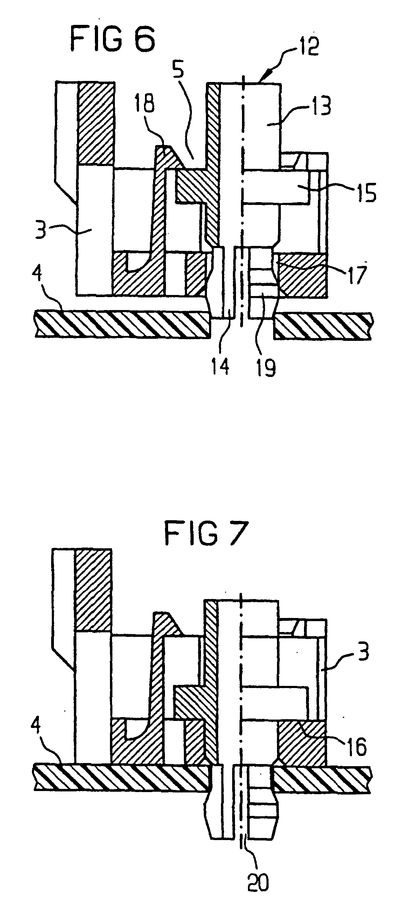

Die Haltevorrichtung 1 weist ein Rahmenteil 3 auf, an dessen äußeren Rändern Befestigungspunkte 5 zum Befestigen des Rahmenteils 3 auf einer als Trägerplatte dienenden Leiterplatte 4 vorgesehen sind. Die Ausbildung des Rahmenteils 3 ist derart, dass es auf der Leiterplatte 4 einen Direktstecker 6 (Figur 5) umrahmt. Der Direktstecker 6 ist in den Figuren 1 bis 3 nicht explizit angegeben. Derartige Stecker sind aber bekannt. Es handelt sich um Steckerleisten, in die Leiterplatten eingesteckt werden können.

Am Rahmenteil 3 sind an zwei gegenüberliegenden Seiten zum Führen und Halten eines senkrecht in den Direktstecker 6 einzusteckenden bzw. eingesteckten Prozessormoduls senkrecht von der Leiterplatte 4 abstehende Führungsschienenstutzen 7 starr angeformt.

Zur Befestigung der Haltevorrichtung 1 sind Brücken 8 vorgesehen, die auf der Unterseite der Leiterplatte 4 beispielsweise eingepresst sind. Die Brücken 8 bestehen aus biegesteifem Material und weisen an jeweiligen Enden Befestigungspunkte 9 auf. Die Befestigungspunkte 9 sind den jeweiligen Befestigungspunkten 5 des Rahmenteils 3 auf der gegenüberliegenden Seite der Leiterplatte 4 zugeordnet. An Stellen, an denen die Befestigungspunkte 5, 9 des Rahmenteils 3 und der Brücken 8 jeweils einander gegenüberliegen, sind in der Leiterplatte 4 fluchtende Öffnungen vorgesehen, um einen Durchgriff von Befestigungsmitteln 10 zu ermöglichen.

Als Befestigungselemente 10 sind im Ausführungsbeispiel gemäß der Figuren 1 bis 3 Schrauben verwendet. Im einzelnen bestehen die Schraubenbefestigungselemente aus an den Befestigungspunkten 9 der Brücken ausgebildete Schraubenbolzen und aus an den Befestigungspunkten 5 des Rahmenteils 3 vorgesehenen hülsenförmigen Schraubenmuttern. Die Schraubenmuttern dienen den Schrauben als Konterelement.

Die Befestigung der Haltevorrichtung 1 auf der Leiterplatte 4 erfolgt dadurch, dass die Leiterplatte 4 zwischen dem Rahmenteil 3 und den Brücken 8 durch Festziehen der Schraubenbefestigungselemente eingeklemmt wird.

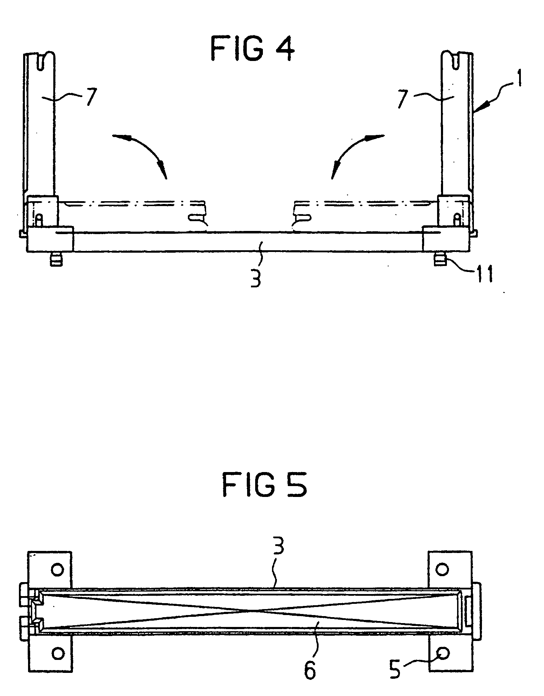

Bei der Haltevorrichtung 1 in den Figuren 4 und 5 sind die Führungsschienenstutzen 7 gelenkig mit dem Rahmenteil 3 verbunden. Die gelenkige Verbindung ist derart ausgeführt, dass die Führungsschienenstutzen 7 einklappbar sind. Das Profil der Führungsschienenstutzen 7 ist U-förmig, so dass sie im eingeklappten Zustand einen zwischen dem Rahmenteil 3 angeordneten Direktstecker 6 zwischen sich aufnehmen können. Der Raumbedarf der Haltevorrichtung 1 auf der in den Figuren 4 und 5 nicht näher dargestellten Leiterplatte 4 wird durch eingeklappte Führungsschienenstutzen 7 minimiert.

Zum Befestigen des Rahmenteils 3 und damit der Haltevorrichtung 1 auf der Leiterplatte 4 sind in den Figuren 4 und 5 am Rahmenteil 3 an den Befestigungspunkten 5 einstückig angeformte Spreizkrallen 11 für einen Durchgriff durch die fluchtenden Öffnungen an der Leiterplatte 4 vorgesehen. Die Spreizkrallen 11 sind an den Befestigungspunkten 5 gruppenweise um eine senkrecht vom Rahmenteil nach unten abstehende Achse symmetrisch verteilt gruppiert. Sie sind quer zur Achse federnd ausgebildet. Für eine nähere Beschreibung der Spreizkrallen 11 wird auf die Ausführungen zu den Figuren 6 und 7 verwiesen.

In den Figuren 6 und 7 sind zum Befestigen des Halterahmens 3 und damit der Haltevorrichtung 1 als Befestigungselemente 10 an einem Befestigungspunkt 5 des Rahmenteils 3 Einschnappbolzen 12 verwendet. In der Figur 6 ist der Einschnappbolzen 12 in einer ersten Bewegungsstellung zu sehen, in der er noch nicht durch eine fluchtende Öffnung in der Leiterplatte 4 gedrückt ist. In der Figur 7 ist der Einschnappbolzen 12 in einer zweiten Bewegungsstellung gezeigt, in der er durch eine fluchtende Öffnung in der Leiterplatte 4 gedrückt ist.

Ein Einschnappbolzen 12 weist ein breiteres Oberteil 13 und ein schmäleres, einstückig mit dem Oberteil 13 verbundenes Unterteil 14 auf. Das Unterteil 14 entspricht in seiner prinzipiellen Ausbildung der Ausbildung einer Gruppe von Spreizkrallen 11, wie sie im Zusammenhang mit den Figuren 4 und 5 beschrieben sind. Eine Spreizkrallengruppe umfasst dabei mindestens 2 Einzelspreizkrallen, die sich in Richtung einer Längsachse des Oberteils ausdehnen.

Das Oberteil 13 weist am äußeren Umfang einen umlaufend angeordneten Absatzring 15 auf, mit dem der Einschnappbolzen 12 im eingedrückten Zustand (Figur 7) an Anlageschultern 16 von zylindrischen Öffnungen 17 des Rahmenteils 3 anliegt. Der Absatzring 15 dient gemäß der Figur 6 gleichzeitig als Anschlagbegrenzung gegen ein ungewolltes Herausfallen aus dem Befestigungspunkt 5. Dazu ist eine Haltenase 18 vorgesehen, die den Einschnappbolzen 12 in Richtung eines Abziehens von der Leiterplatte 4 an einer Stelle festhält, an der das Rahmenteil 3 von der Leiterplatte 4 lösbar ist, der Einschnappbolzen 12 selber aber noch nicht aus der zylindrischen Öffnung 17 des Rahmenteils 3 entfernt ist. Er ist noch in der zylindrischen Öffnung 17 des Rahmenteils 3 geführt.

Das Unterteil 14 weist beispielsweise drei Spreizkrallen 19 auf, die in ihrer Ausgestaltung mit den Spreizkrallen 11 der Figuren 4 und 5 korrespondieren. Das nachfolgend zu den Spreizkrallen 19 Gesagte kann daher auch auf die Spreizkrallen 11 der Figuren 4 und 5 gelesen werden kann.

Die Spreizkrallen 19 weisen in einem Ansatzbereich, der unmittelbar an das Oberteil 13 anschließt, einen solchermaßen verengten Umfang auf, dass der Umfang an den Durchmesser der fluchtenden Durchgangsöffnungen der Leiterplatte 4 angepasst ist, derart, dass dieser Umfang im eingedrückten Zestand des Einschnappbolzens 12 gerade in die Durchgangsöffnung der Leiterplatte 4 passt (Figur 7). Weiter weisen die Spreizkrallen 19 als Gruppe in einem Mittelbereich einen erweiterten Umfang auf, derart, dass im eingedrückten Zustand des Einschnappbolzens 12 dieser Umfang außerhalb der Durchgangsöffnung der Leiterplatte 4 größer ist als die Durchgangsöffnung der Leiterplatte 4. In einem freien Endbereich weisen die Spreizkrallen 19 einen konischen Zulauf auf, derart, dass ein kleinster Durchmesser am Ende der Spreizkrallen 19 kleiner ist als die Durchgangsöffnung der Leiterplatte 4.

Beim Eindrücken der Einschnappbolzen 12 in die Durchgangsöffnungen der Leiterplatte 4 zentrieren sich die Einschnappbolzen durch den konischen Zulauf am freien Ende selbst. Durch den dickeren Mittelbereich werden die Spreizkrallen 19 dann zunächst quer zur Achse, um die herum sie angeordnet sind, zusammengedrückt und schnappen dann im Endzustand wieder auseinander. Das Rahmenteil 3 ist dadurch auf der Leiterplatte 4 fixiert. Damit sich die Spreizkrallen 19 zusammendrücken können, befinden sich zwischen den Spreizkrallen 19 freie Spalten 20.

Weisen die Einschnappbolzen 12 an der Stelle der Längsachse entlang des Längsachsenverlaufs eine Durchgangsöffnung zum Einbringen eines Klemm- bzw. Einschnappstiftes auf, wird bei vorhandenem Klemm- bzw. Einschnappstift ein Zurückdrücken der Spreizkrallen und damit wiederum ein Herausrutschen des Einschnappbolzens 12 aus der Durchgangsöffnung der Leiterplatte 4 verhindert.

Ist das Oberteil 13 des Einschnappbolzens 12 becherartig ausgebildet und ist an den Innenwänden der becherartigen Ausbildung des Oberteils 13 eine durch kleine, zum Beispiel nippelartige Ausbildungen eine Durchmesserverengung hergestellt, die so bemessen ist, dass der frei bleibende Durchmesser für ein Kopfteil eines mit einem verbreiterten Kopfteil versehenen Klemm- bzw. Einschnappstiftes unter Anwendung eines erhöhten Einpressdrucks gerade noch passierbar ist, und dass das Kopfteil eines in die Durchgangsöffnung des Einschnappbolzens 12 eingebrachten Klemm- bzw. Einschnappstiftes in seiner Endstellung nach der Durchmesserverengung beabstandet ist, ist der Klemm- bzw. Einschnappstift gegen ein unbeabsichtigtes Herausfallen gesichert.

Die Einschnappbolzen 12 können wie auch die Spreizkrallen 11 aus lötbarem Material bestehen, so dass sie gelötet werden können. Weisen die Spreizkrallen 11, 19 einen solchen äußeren Kantenverlauf auf, dass für das Lot beim Löten eine Kapillarwirkung besteht, werden mechanisch verstärkte Lötstellen erzielt, weil sich mehr Lot an den Lötstellen ansammelt.

## Patentansprüche

1. Vorrichtung zum Halten von Prozessormodulen auf Trägerplatten, umfassend ein an äußeren Rändern zum Befestigen auf der Trägerplatte Befestigungspunkte mit zugeordneten Befestigungsmittel aufweisendes Rahmenteil, das auf der Trägerplatte einen für das Prozessormodul vorgesehenen Direktstecker umrahmt, sowie umfassend zwei an gegenüberliegenden Seiten des Rahmenteils zum Führen und Halten eines senkrecht zur Trägerplatte in den Direktstecker einzusteckenden bzw. eingesteckten Prozessormoduls angeordnete, senkrecht von der Trägerplatte abstehende Führungsschienenstutzen, **dadurch gekennzeichnet, dass** die Führungsschienenstutzen (7) an dem Rahmenteil (3) einklappbar gehaltert sind und dass die Befestigungspunkte mit den zugeordneten Befestigungsmitteln in Weisen ausgebildet sind, die entweder eine Schraub-, Klemm- oder Einschnappbefestigung des Rahmenteils an der Trägerplatte ermöglichen.

2. Vorrichtung nach Anspruch 1, **dadurch gekennzeichnet, dass** die an dem Rahmenteil (3) vorgesehenen Befestigungspunkte (5) durch zylindrische Öffnungen mit Anlageschultern (16) gebildet sind, in denen unter einer Anlage an die Anlageschultern (16) Einschnappbolzen (12) mit für einen Durchgriff durch an der Trägerplatte vorgesehene fluchtende Öffnungen zur Befestigung des Rahmenteils (3) an der Trägerplatte um eine Längsachse des Einschnappbolzens (12) symmetrisch verteilt angeordneten, quer zur Längsachse federnden Spreizkrallen (19) vorgesehen sind.

3. Vorrichtung nach Anspruch 1, **dadurch gekennzeichnet, dass** an den Befestigungspunkten (5) des Rahmenteils (3) einstückig mit dem Rahmenteil (3) verbundene, für einen Durchgriff durch an der Trägerplatte vorgesehene fluchtende Öffnungen zur Befestigung des Rahmenteils (3) an der Trägerplatte um eine senkrecht nach unten vom Rahmenteil (3) abstehende Achse symmetrisch verteilt angeordnete, quer zur Achse federnde Spreizkrallen (11) vorgesehen sind.

4. Vorrichtung nach einem der Ansprüche 2 bis 3, **dadurch gekennzeichnet, dass** die Spreizkrallen (11; 19) mit einem für Lötungen geeigneten Material gefertigt sind und in Bezug auf die Trägerplatte einen eine Kapillarwirkung eines bei den Lötungen verwendeten Lotes unterstützenden Kantenverlauf haben.

5. Vorrichtung nach einem der Ansprüche 2 bis 4, **dadurch gekennzeichnet, dass** die um eine jeweilige Längsachse bzw. Achse symmetrisch verteilt angeordneten Spreizkrallen (11; 19) insgesamt in einem Ansatzbereich zu einem Oberteil des Einschnappbolzens (12) bzw. zu dem Rahmenteil (3) in Anpassung an den Durchmesser der fluchtenden Öffnungen in der Trägerplatte einen verengten Umfang, in einem nach einem Durchgriff durch die fluchtenden Öffnungen an der Trägerplatte außerhalb liegenden Bereich einen erweiterten Umfang und in einem freien Endbereich eine konische Verjüngung bis zu einem Durchmesser kleiner dem Durchmesser der fluchtenden Öffnungen der Trägerplatte aufweisen.

6. Vorrichtung nach einem der Ansprüche 2 bis 5, **dadurch gekennzeichnet, dass** die Einschnappbolzen (12) mit einem Oberteil (13) ausgebildet sind, das einen am äußeren Umfang umlaufend angeordneten Absatzring (15) aufweist, und mit einem Unterteil (14) ausgebildet ist, das aus wenigstens zwei sich in Richtung einer Längsachse des Oberteils (13) ausdehnenden, symmetrisch um die Längsachse herum verteilt angeordneten, quer zur Längsachse federnden Spreizkrallen (19) besteht, die insgesamt in einem Ansatzbereich zu dem Oberteil (13) in angepasster Weise an einen Durchmesser einer in einer Trägerplatte vorgesehenen Durchgangsöffnung einen verengten Umfang, in einem mittleren Bereich einen erweiterten Umfang und in einem freien Endbereich eine konische Verjüngung bis zu einem Durchmesser kleiner als der Durchmesser der Durchgangsöffnung der Trägerplatte aufweisen, und dass die am Rahmenteil vorgesehenen Befestigungspunkte in der Weise ausgebildet sind, dass die Einschnappbolzen (12) mit Rückhalteelementen (18) an den Absatzringen (15) unverlierbar gehalten sind.

7. Vorrichtung nach einem der Ansprüche 2 bis 6, **dadurch gekennzeichnet, dass** an den Längsachsen bzw. Achsen, um die herum die Spreizkrallen (11; 19) angeordnet sind, Durchgangsbohrungen zum Einbringen von Klemm- bzw. Einschnappstiften vorgesehen sind.

## Claims

1. Arrangement for retaining processor modules on mounting boards, comprising a frame part which has on outer borders, for the purpose of fastening on the mounting board, fastening points with associated fastening means and, on the mounting board, surrounds a direct plug connector provided for the processor module, and also comprising two guide rail stubs which project vertically from the mounting board and are arranged on opposite sides of the frame part, for the purpose of guiding and retaining a processor module which is to be plugged, or has been plugged, into the direct plug connector perpendicularly to the mounting board, **characterized in that** the guide rail stubs (7) are secured on the frame part (3) with swing-in action, and **in that** the fastening points with the associated fastening means are designed to allow screw fastening, clamping fastening or snap-in fastening of the frame part on the mounting board.

2. Arrangement according to Claim 1, **characterized in that** the fastening points (5), which are provided on the frame part (3), are formed by cylindrical openings with abutment shoulders (16), in which there are provided, with abutment against the abutment shoulders (16), snap-in bolts (12) with expanding claws (19) which are distributed symmetrically about a longitudinal axis of the snap-in bolt (12) for a through-passage through aligned openings provided on the mounting board, for the purpose of fastening the frame part (3) on the mounting board, and are resilient transversely to the longitudinal axis.

3. Arrangement according to Claim 1, **characterized in that** provided at the fastening points (5) of the frame part (3) are expanding claws (11) which are connected integrally with the frame part (3), are distributed symmetrically, about an axis projecting vertically downward from the frame part (3), for a through-passage through aligned openings provided on the mounting board, for the purpose of fastening the frame part (3) on the mounting board, and are resilient transversely to the axis.

4. Arrangement according to either of Claims 2 and 3, **characterized in that** the expanding claws (11; 19) are produced using material suitable for soldering and, in relation to the mounting board, have an edge profile which assists a capillary action of a solder used during soldering.

5. Arrangement according to one of Claims 2 to 4, **characterized in that** the expanding claws (11; 19), which are distributed symmetrically about a respective longitudinal axis or axis, have overall, in a region of attachment to a top part of the snap-in bolt (12) or to the frame part (3), respectively, in adaptation to the diameter of the aligned openings in the mounting board, a narrowed circumference and, in a region located outside the mounting board following through-passage through the aligned openings, a widened circumference and, in a free end region, conical tapering to a diameter smaller [lacuna] the diameter of the aligned openings of the mounting board.

6. Arrangement according to one of Claims 2 to 5, **characterized in that** the snap-in bolts (12) are designed with a top part (13), which has an offset ring (15) arranged around the outer circumference, and is [sic] designed with a bottom part (14), which comprises at least two expanding claws (19) which extend in the direction of a longitudinal axis of the top part (13), are distributed symmetrically about the longitudinal axis, are resilient transversely to the longitudinal axis and have overall, in a region of attachment to the top part (13), in adaptation to a diameter of a through-passage opening provided in a mounting board, a narrowed circumference and, in a central region, a widened circumference and, in a free end region, conical tapering to a diameter smaller than the diameter of the through-passage opening of the mounting board, and **in that** the fastening points provided on the frame part are designed such that the snap-in bolts (12) are retained in captive fashion on the offset rings (15) by way of restraining elements (18).

7. Arrangement according to one of Claims 2 to 6, **characterized in that** through-passage bores for the introduction of clamping or snap-in pins are provided on the longitudinal axes or axes about which the expanding claws (11; 19) are arranged.

## Revendications

1. Dispositif de maintien de modules processeurs sur des cartes de support, comprenant une partie formant cadre présentant sur des bords extérieurs des points de fixation destinés à la fixation sur la carte de support et auxquels sont associés des moyens de fixation, laquelle partie formant cadre entoure sur la carte de support un connecteur direct prévu pour le module processeur, et comprenant deux bouts de rail de guidage faisant saillie verticalement de la carte de support et disposés sur des côtés opposés de la partie formant cadre, pour guider et maintenir un module processeur enfiché ou à enficher dans le connecteur direct, perpendiculairement à la carte de support, **caractérisé en ce que** les bouts de rail de guidage (7) sont fixés sur la partie formant cadre (3) de façon à pouvoir être repliés et que les points de fixation et les moyens de fixation associés sont réalisés de façon à permettre une fixation par vissage, blocage ou encliquetage de la partie formant cadre sur la carte de support.

2. Dispositif selon la revendication 1, **caractérisé en ce que** les points de fixation (5) prévus sur la partie formant cadre (3) sont formés par des ouvertures cylindriques avec des épaulements d'appui (16) dans lesquelles sont prévus des axes d'encliquetage (12) prenant appui contre les épaulements d'appui (16) et comportant des griffes écartables (19) qui ont une élasticité transversalement à un axe longitudinal de l'axe d'encliquetage (12) et sont réparties symétriquement autour de l'axe longitudinal, pour passer dans des ouvertures en alignement prévues sur la carte de support afin de fixer la partie formant cadre (3) sur la carte de support.

3. Dispositif selon la revendication 1, **caractérisé en ce qu'**au niveau des points de fixation (5) de la partie formant cadre (3), il est prévu des griffes écartables (11) liées d'une pièce à la partie formant cadre (3), réparties symétriquement autour d'un axe faisant saillie verticalement vers le bas de la partie formant cadre (3), pour passer dans des ouvertures en alignement prévues sur la carte de support afin de fixer la partie formant cadre (3) sur la carte de support, et présentant une élasticité transversalement à l'axe.

4. Dispositif selon l'une des revendications 2 à 3, **caractérisé en ce que** les griffes écartables (11 ; 19) sont fabriquées en un matériau susceptible d'être brasé et ont des bords dont le tracé par rapport à la carte de support favorise un effet capillaire d'un matériau d'apport de brasage utilisé pour les brasages.

5. Dispositif selon l'une des revendications 2 à 4, **caractérisé en ce que** les griffes écartables (11 ; 19) réparties symétriquement autour d'un axe longitudinal ou d'un axe présentent dans l'ensemble, dans une zone de raccordement avec une partie supérieure de l'axe d'encliquetage (12) ou avec la partie formant cadre (3), un pourtour rétréci adapté au diamètre des ouvertures en alignement dans la carte de support, un pourtour élargi dans une zone située à l'extérieur après le passage dans les ouvertures en alignement dans la carte de support, et dans une zone terminale libre, une terminaison conique de jusqu'à un diamètre inférieur au diamètre des ouvertures en alignement dans la carte de support.

6. Dispositif selon l'une des revendications 2 à 5, **caractérisé en ce que** les axes d'encliquetage (12) comportent une partie supérieure (13) qui présente un gradin en forme de bague (15) circulaire sur le pourtour extérieur, et une partie inférieure (14) qui est formée d'au moins deux griffes écartables (19) s'écartant dans la direction d'un axe longitudinal de la partie supérieure (13), réparties symétriquement autour de l'axe longitudinal et présentant une élasticité transversalement à l'axe longitudinal, lesquelles griffes écartables présentent dans l'ensemble, dans une zone de raccordement avec la partie supérieure (13), un pourtour rétréci adapté à un diamètre d'une ouverture de passage prévue dans la carte de support, un pourtour élargi dans une zone centrale, et dans une zone terminale libre, une terminaison conique de jusqu'à un diamètre inférieur au diamètre de l'ouverture de passage dans la carte de support, et que les points de fixation prévus sur la partie formant cadre sont réalisés de telle manière que les axes d'encliquetage (12) sont fixés de manière imperdable par des éléments de retenue (18) sur les gradins en forme de bague (15).

7. Dispositif selon l'une des revendications 2 à 6, **caractérisé en ce que** des ouvertures de passage destinées à l'insertion de tiges de blocage ou d'encliquetage sont prévues sur les axes longitudinaux ou les axes autour desquels sont disposées les griffes écartables (11 ; 19).
